Europäisches Patentamt

European Patent Office

Office européen des brevets

(11) Publication number: **0 050 694**
**B1**

## (12) EUROPEAN PATENT SPECIFICATION

(45) Date of publication of patent specification: **13.02.85**

(21) Application number: **80303822.3**

(22) Date of filing: **28.10.80**

(51) Int. Cl.⁴: **H 05 K 13/00**

(54) **Entry material and method for drilling circuit boards.**

(43) Date of publication of application:
**05.05.82 Bulletin 82/18**

(45) Publication of the grant of the patent:
**13.02.85 Bulletin 85/07**

(84) Designated Contracting States:
**AT BE CH DE FR GB IT LI LU NL SE**

(56) References cited:
**US-A-3 388 036**
**US-A-3 617 613**
**US-A-3 700 341**
**US-A-3 897 588**
**US-A-3 972 765**
**US-A-4 019 826**

(73) Proprietor: **LCOA LAMINATING COMPANY OF**
**AMERICA**
**7311 Doig Drive**
**Garden Grove California 92641 (US)**

(72) Inventor: **Block, James P.**
**5868 Deborah Street**
**Long Beach California 90815 (US)**

(74) Representative: **Carpmael, John William**
**Maurice et al**
**CARPMAELS & RANSFORD 43 Bloomsbury**
**Square**
**London, WC1A 2RA (GB)**

Courier Press, Leamington Spa, England.

## Description

This invention relates to the fabrication of printed circuit boards, and more particularly to an improved entry material and method for the drilling of such boards.

In manufacturing printed circuit boards for use in electrical and electronic equipment, many holes are drilled through these boards to accommodate component leads and support members. If the drill is applied directly to the surface of the board, it has been found that certain intolerable imperfections appear in the board surfaces, such as drill entry burrs, pressure foot marks from the pressure feet which are used for holding the workpiece in position during the drilling operation, and marks from particles which fall from the drill onto the surface of the boards which, with contact on this surface of the pressure foot or drill bushing, become driven into the surface of the board. Further, drill wander is often encountered when the drill strikes the surface of the board resulting in misalignment of the drilled hole.

To alleviate this problem, the use of an entry foil has been resorted to, as described in my U.S. Patent No. 4,019,826, dated April 26, 1977, in which an aluminium entry foil is placed on top of a circuit board to be drilled and drilling takes place through the aluminium entry foil and circuit board in succession.

It is also known from U.S. Patent No. 3,700,341 to employ a laminated board formed of pressed wood with aluminium outer foil layers as a black-up board when drilling printed circuit boards. Prepublished U.S. specification 3,897,588 discloses a process for the production of metal clad laminates with a core of glass-cellulose sheets. While the use of the type of entry foil disclosed in U.S. Patent specification 4,019,826 has greatly reduced the aforementioned problems, in certain instances difficulties are encountered, particularly in situations where the pressure foot for holding the workpiece in place during drilling is placed some distance from the drill. In such instances, a portion of the entry foil in the area of the drill tends to lift off the workpiece in an "oil canning" effect, causing drill debris to get between it and the printed circuit board, thereby diminishing, if not entirely defeating, the desired effects of the entry foil. It has also been found that with the use of drills which operate at higher r.p.m. and feed rates to more rapidly remove material, the relatively thin (0.0127 cm) (5 mil) entry foil is not strong enough to support such high torsional forces. While this problem could be alleviated by using a thicker foil, this would greatly increase the cost of the entry material and cause the generation of greater heat with its resultant increased wear on the drill bit.

The entry material employed in the present invention overcomes the aforementioned shortcomings of the prior art by providing a high strength entry material that is not subject to the aforementioned "oil canning" effect and can withstand high r.p.m., high feed rate drilling. This end result is achieved at a substantially lower cost than would be incurred were an entry sheet thick enough to have similar properties to be used. In addition, the entry material of the present invention provides more efficient heat sink cooling action for the drill than afforded with prior art entry foils. This end result is achieved by employing a substrate sheet made of a wood pulp-glass composite, flat sheets of aluminium foil being bonded to the opposite flat surfaces of this substrate with a suitable epoxy bonding agent. Optimum thicknesses of the various sheets and bonding techniques for joining them together have been developed to provide an integrated entry material having optimum characteristics and which is relatively economical.

It is therefore an object of this invention to provide an improved entry material for use in drilling printed circuit boards.

It is a further object of this invention to provide an entry material for use in drilling printed circuit boards which is not subject to "oil canning" effect and which can handle high r.p.m. and high feed rate drilling.

It is a further object of this invention to provide an entry material for use in drilling printed circuit boards which has improved heat sink properties for reducing the temperature of the drill.

Other objects of this invention will become apparent as the description proceeds in connection with the accompanying drawings of which:

Fig. 1 is an exploded view of a preferred embodiment of the entry material of the invention;

Fig. 2 is a schematic drawing illustrating the fabrication of the entry material of the invention;

Fig. 3 is an exploded view illustrating the use of the entry material of the invention; and

Fig. 4 is a perspective view further illustrating the use of the entry material of the invention.

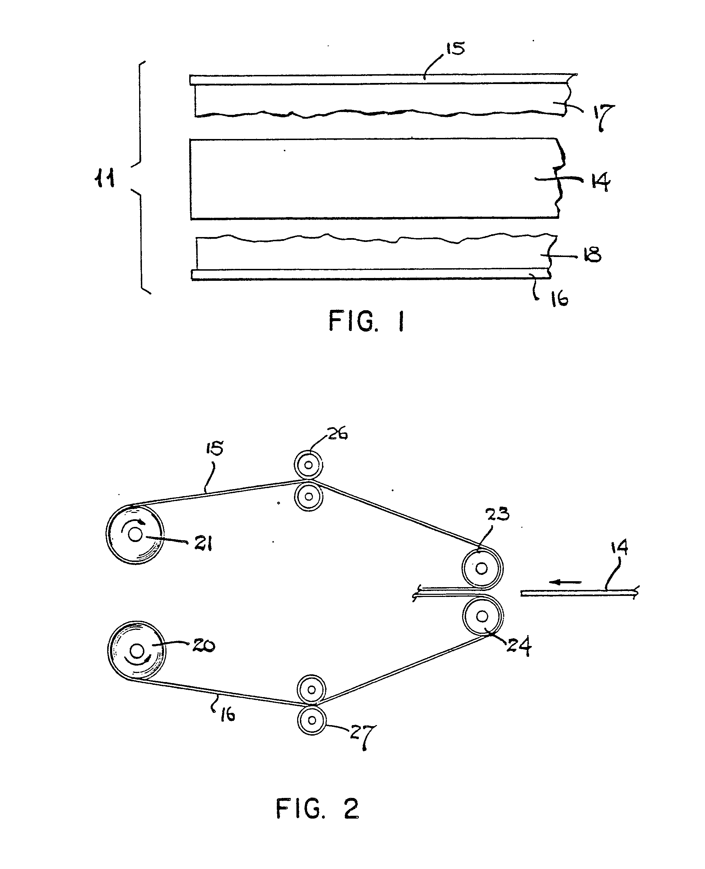

Referring now to Fig. 1, the components of a preferred embodiment of the entry material 11 of the invention are shown in exploded form. A substrate or core sheet 14 has sheets of aluminium 15 and 16 bonded to the opposite surfaces thereof by means of layers of epoxy bonding agent 17 and 18. Substrate or core 14 is fabricated of a hardwood pulp fiberglass composite which preferably is formed from 70% hardwood pulp and 30% unwoven glass fiber. Substrate 14 may be between .025—.32 cm (0.10 and .125 inches) thick with .046 cm (0.18 inches) having been found to be optimum thickness for most application requirements. Foil sheets 15 and 16 are preferably of a commercially available aluminium foil. This foil is composed of 0.6% silicon, 0.7% iron, 0.05—0.20% copper, 1.0—1.5% manganese, 0.01% zinc, and the remainder pure aluminium. The thickness of the aluminium foil sheets may be between .0025—.018 cms (.001 and .007 inches), an optimum thickness being 0.005 cm (.002 inches). Adhesive layers 17 and 18 are preferably .017 cm (.0065 inches) in thickness, but may be between .0025 and .051 cm (.001 and .020 inches).

Referring now to Fig. 2, the fabrication of the entry material of the invention is schematically illustrated. Aluminium foil 15 and 16 is drawn off rolls of such foil 20 and 21 by means of pinch rollers 23 and 24 through which the foil is drawn. Between the pinch rollers 23 and 24 and rolls 20 and 21, the foil passes over adhesive coating rollers 26 and 27 which coat the outer surfaces of the foil with an epoxy bonding agent. A sheet of the core or substrate 14 is passed through pinch rollers 23 and 24 between foil sheets 15 and 16 which are adhered to the opposite surfaces thereof. Typically, core sections about 96.5 cm × 127 cms (38″ × 50″) are used and the foil and core after being bonded together are cut along the edges to provide a board 91.4 cm × 121.9 cm (36″ × 48″). The bonding agent employed is an epoxy bonding agent formed from 50% epoxy resin and 50% hardener which is layered onto the surface of the aluminium sheets to a thickness of .015—.018 cm (.006—.007 inches). The substrate 14, as already mentioned, is preferably a 70% hardwood pulp — 30% fiberglass composite having a thickness of .046 cm (.018 inches), and the aluminium foil is .005 cm (.002 inches) thick. After the aluminium sheets have been adhered to substrate 14 and cut along the edges of such substrate, the material thus formed is placed between a pair of tooling or "caul" plates which are placed into a heated laminating press where heat and pressure are applied to the plates. In this process, the epoxy bonding agent thoroughly impregnates the substrate material. Typically, $344 \times 10^3$ Nm$^{-2}$ (50 psi) is applied at about 98°C (210°F) for about 2 minutes to thoroughly flatten, cure and laminate the material. The entry material of the preferred embodiment has an overall thickness of 0.889 cm (.035 inches) prior to placement in the press but after heat and pressure have been applied ends up with an overall thickness of 0.38 cm (.015 inches).

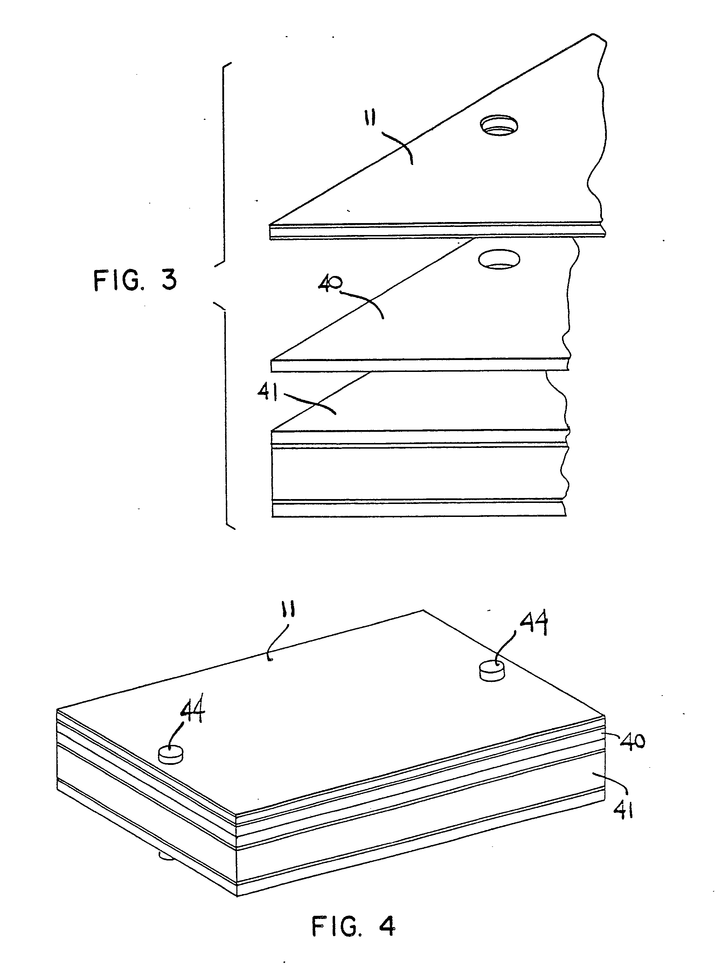

Referring now to Figs. 3 and 4, the use of the entry material in the drilling of a printed circuit board is illustrated. Circuit board 40 to be drilled is held against back-up board 41 which may be of the type of board described in ny U.S. Patent 3,700,341 by means of dowel pins 44. The unit is then placed in the drill machine for the drilling operation.

## Claims

1. A method for drilling a printed circuit board (40) comprising

placing a sheet (11) of entry material on top of said printed circuit board and drilling through the entry material and printed circuit board in succession, characterised in that said entry material is formed from a substrate of a wood pulp fiberglass composite (14) having a thickness of .025—0.32 cm (0.101—.125 inches) and sheets of aluminium foil (15) bonded to the opposite surfaces of said substrate (14), said aluminium foil (15) having a thickness of .0025—.018 cm (.001—.007 inches).

2. The method of claim 1 characterised in that the aluminium foil (15) is bonded to said substrate (14) with an epoxy bonding agent (17) comprised of 50% epoxy resin and 50% hardener which is layered between the foil and the substrate to a thickness of .015—.018 cm (.006—.007 inches).

3. The method of claims 1 or 2 characterised in that the aluminium foil (15) has a thickness of .005 cm (.002 inches) and the substrate (14) has a thickness of 0.046 cm (.018 inches).

4. The method of claim 2 characterised in that after the bonding agent (17) has been applied, heat is applied to the foil (15) and substrate (14) while the foil is compressed against the substrate so as to cause the bonding agent to thoroughly impregnate the substrate.

5. The method of claim 1 characterised in that the substrate (14) is fabricated of a 70% hardwood pulp—30% fiberglass composite.

6. An entry material (11) for placing on top of a printed circuit board (40) while drilling characterised in that it comprises

first and second similar sheets of aluminium foil (15) in opposing relationship to each other, said foil having a thickness of about .005 cm (.002 inches).

a substrate member (14) sandwiched between said sheets of aluminium foil, said substrate member being a sheet about .046 cm (.018 inches) in thickness formed from a composite of 70% wood pulp and 30% fiberglass, and layer (17) for bonding said sheets to said substrate.

7. The material of claim 6 characterised in that said bonding layer (17) comprises an epoxy bonding agent formed from 50% epoxy resin and 50% hardener which is layered between the aluminium foil and the substrate to a thickness of approximately .015 to .018 cm (.006—.007 inches).

## Revendications

1. Procédé pour percer une plaquette (40) à circuit imprimé consistant

à placer une feuille (11) d'une matière d'entrée sur le dessus de ladite plaquette à circuit imprimé et à percer successivement à travers la matière d'entrée et la plaquette à circuit imprimé, caractérisé en ce que ladite matière d'entrée est formée d'un substrat d'un composite (14) de pâte de bois et de fibres de verre ayant une épaisseur de 0,025—0,32 cm (0,010—0,125 inch) et de plaques en mince feuille d'aluminium (15) liées aux surfaces opposées dudit substrat (14), ladite mince feuille d'aluminium (15) ayant une épaisseur de 0,0025—0,018 cm (0,001—0,007 inch).

2. Procédé selon la revendication 1, caractérisé en ce que la mince feuille d'aluminium (15) est liée audit substrat (14) par un agent de liaison époxy (17) constitué à 50 % d'une résine époxy et à 50 % d'un durcisseur, qui forme, entre la mince feuille et le substrat, une couche d'une épaisseur de 0,015—0,018 cm (0,006—0,007 inch).

3. Procédé selon les revendications 1 ou 2, caractérisé en ce que la mince feuille (15) d'aluminium présente une épaisseur de 0,005 cm (0,002 inch) et le substrat (14) présente une épaisseur de 0,046 cm (0,018 inch).

4. Procédé selon la revendication 2, caractérisé en ce que, après que l'agent (17) de liaison a été applique, de la chaleur est appliquée à la mince feuille (15) et au substrat (14), tandis que la mince feuille est comprimée contre le substrat afin de provoquer une imprégnation complète de l'agent de liaison dans le substrat.

5. Procédé selon la revendication 1, caractérisé en ce que le substrat (14) est fabriqué d'un composite à 70 % de pâte de feuillu et 30 % de fibres de verre.

6. Matière d'entrée (11) destinée à être placée sur le dessus d'une plaquette (40) à circuit imprimé pendant le perçage, caractérisé en ce qu'elle comprend

des première et seconde plaques similaires en mince feuille (15) d'aluminium, opposées l'une à l'autre, ladite mince feuille ayant une épaisseur d'environ 0,005 cm (0,002 inch),

un élément (14) de substrat serré entre lesdites plaques de la mince feuille d'aluminium, ledit élément de substrat étant une plaque d'environ 0,046 cm (0,018 inch) d'épaisseur, formée d'un composite à 70 % de pâte de bois et 30 % de fibres de verre, et une couche (17) pour lier lesdites plaques audit substrat.

7. Matière selon la revendication 6, caractérisée en ce que ladite couche (17) de liaison comprend un agent de liaison époxy formé à 50 % d'une résine époxy et à 50 % d'un durcisseur, qui forme, entre la mince feuille d'aluminium et le substrat, une couche d'une épaisseur d'environ 0,015 à 0,018 cm (0,006—0,007 inch).

## Patentansprüche

1. Verfahren zur Herstellung von Bohrungen in einer gedruckten Schaltungsplatte (40),
bei dem ein Blatt (11) eines Eintrittmaterials auf die gedruckte Schaltungsplatte aufgelegt wird und das Eintrittmaterial und die gedruckte Schaltungsplatte aufeinanderfolgend durchbohrt werden, dadurch gekennzeichnet, daß das Eintrittmaterial aus
einem aus einem Holzbrei und Fiberglas zusammengesetzten Substrat (14) mit einer Stärke von 0,025—0,32 cm (0,010—0,125 inches) und
mit den beiden entgegengesetzten Oberflächen dieses Substrats (14) verbundenen Aluminiumfolien (15) mit einer Stärke von 0,0025—0,018 cm (0,001—0,007 inches) gebildet wird.

2. Verfahren nach Anspruch 1, dadurch gekennzeichnet, daß die Aluminiumfolie (15) mit dem genannten Substrat (14) mit Hilfe eines Epoxid-Bindemittels verbunden ist, das aus 50% eines Epoxid-Harzes und 50% Härter besteht und zwischen der Aluminiumfolie und dem Substrat in einer Stärke von 0,015—0,018 cm (0,006—0,007 inches) eingebracht wird.

3. Verfahren nach Anspruch 1 oder 2, dadurch gekennzeichnet, daß die Aluminiumfolie (15) eine Stärke von etwa 0,005 cm (0,002 inches) und das Substrat (14) eine Stärke von 0,046 cm (0,018 inches) besitzt.

4. Verfahren nach Anspruch 2, dadurch gekennzeichnet, daß nach dem Aufbringen des Bindemittels (17) die Aluminiumfolie (15) und das Substrat (14) mit Wärme beaufschlagt werden, während die Aluminiumfolie gegen das Substrat gepreßt wird, derart daß das Substrat von dem Bindemittel durchgehend getränkt wird.

5. Verfahren nach Anspruch 1, dadurch gekennzeichnet, daß das Substrat (14) aus einer zu 70% aus Hartholzbrei und zu 30% aus Fiberglas bestehenden Zusammensetzung hergestellt wird.

6. Eintrittmaterial (11) zum Auflegen auf eine gedruckte Schaltungsplatte (40) bein derselben, gekennzeichnet durch
ein erstes und ein zweites gleichartiges Blatt aus Aluminiumfolie (15) mit einer Stärke von etwa 0,005 cm (0,002 inches), die einander gegenüberliegend angeordnet sind,
ein zwischen diesen Blättern aus Aluminiumfolie als Zwischenlage angeordnetes blattförmiges Substrat mit einer Stärke von etwa 0,046 cm (0,018 inches), das aus einer Zusammensetzung von 70% Holzbrei und 30% Fiberglas besteht,
sowie eine Verbindungsschicht (17) zur Verbindung der Blätter aus Aluminiumfolie mit dem Substrat.

7. Eintrittmaterial nach Anspruch 6, dadurch gekennzeichnet, daß die Verbindungsschicht (17) ein aus 50% Epoxid-Harz und 50% Härter bestehendes Epoxid-Bindemittel umfaßt, das als Schicht mit einer Stärke von etwa 0,015—0,018 cm (0,006—0,007 inches) zwischen der Aluminiumfolie und dem Substrat angeordnet ist.

0 050 694

FIG. 1

FIG. 2

1

FIG. 3

FIG. 4